# FASCICULE DE BREVET EUROPEEN

(11) **EP 3 041 977 B1**
(45) Date de publication et mention de la délivrance du brevet: **09.10.2019**
(21) Numéro de dépôt: 14744122.4
(22) Date de dépôt: 28.07.2014
(51) Int. Cl.: C30B 29/16, C30B 11/00, C30B 29/06

(54) **PROCEDE ET DISPOSITIF DE TRAITEMENT DE LA SURFACE LIBRE D'UN MATERIAU**
VERFAHREN UND VORRICHTUNG ZUR BEHANDLUNG DER FREIEN OBERFLÄCHE EINES MATERIALS
METHOD AND DEVICE FOR TREATING THE FREE SURFACE OF A MATERIAL

(30) Priorité: 02.09.2013 FR 1358366
(43) Date de publication de la demande: 13.07.2016
(73) Titulaire: Commissariat à l'Énergie Atomique et aux Énergies Alternatives, 75015 Paris (FR)
(72) Inventeur: CHAMPLIAUD, Jonathan, F-01240 Lent (FR); ALBARIC, Mickaël, F-73290 La Motte-Servolex (FR); PATATUT, Loic, F-73370 Le Bourget du Lac (FR)
(74) Mandataire: Novaimo
(86) Numéro de dépôt international: PCT/EP2014/066173
(87) Numéro de publication internationale: WO 2015/028225

(56) Documents cités:
- EP-A1- 1 048 758
- CN-U- 201 971 920
- CN-U- 202 688 502
- DE-A1- 10 064 941
- DE-A1-102013 203 113
- GB-A- 2 490 130
- JP-A- 2004 510 324
- US-A1- 2010 003 405
- US-A1- 2012 137 976

## Description

L'invention concerne le traitement de la surface libre d'un matériau avantageusement contenu dans un récipient, par exemple dans le cadre d'une application à la cristallisation d'un matériau tel que le silicium.

En électronique et en micro-électronique, pour fabriquer des « wafers » (ou plaquettes), on découpe en tranches un lingot généralement en silicium poly-cristallin. Ce lingot est fabriqué par un processus de croissance réalisé par exemple par le procédé DSS (de l'anglais « Directional Solidification System ») de solidification directionnelle. Selon ce procédé DSS, des charges solides de silicium sont placées dans un moule, ou creuset, en forme de parallélépipède, et amenées jusqu'à fusion sous une température contrôlée à l'intérieur d'un four. Après fusion, la solidification démarre dans le bas du moule puis se déplace vers le haut. La fabrication du lingot doit être réalisée sous un flux gazeux d'argon, ou d'un autre gaz neutre, vis-à-vis du bain liquide, comme par exemple de l'hélium ou du néon. Usuellement le niveau de pureté du gaz utilisé est supérieur à 5N. Ce flux gazeux balaie la surface libre du bain de silicium liquide et joue deux rôles. D'une part, il facilite l'évaporation de vapeurs d'oxygène et d'oxyde de silicium, présentes à la surface du bain de silicium en fusion. D'autre part, il protège le bain de silicium de l'atmosphère extérieur.

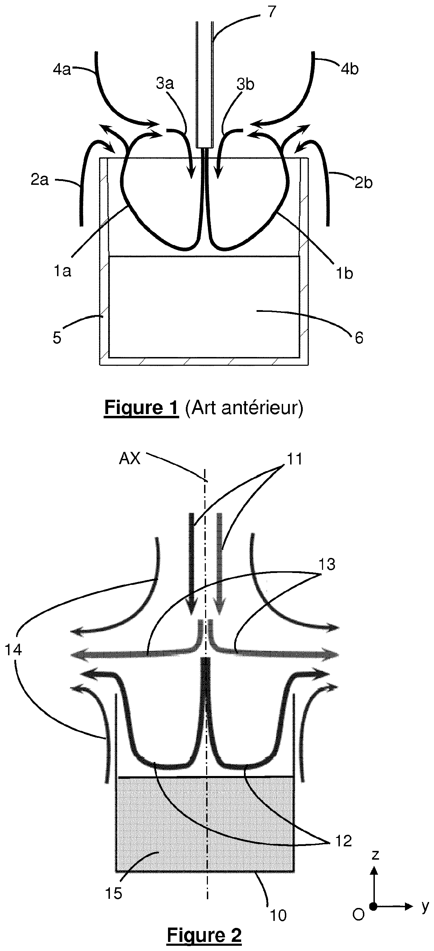

En référence à la figure 1, le flux gazeux est réalisé à l'aide d'une canne de soufflage 7, placée verticalement au-dessus du bain de silicium 6 et dont l'embout inférieur est positionné de façon centrale et à une quinzaine de centimètres au-dessus de la surface du bain 6. En fonctionnement, la canne de soufflage 7 expulse, par son embout inférieur, un flux d'argon dirigé vers le bas et vers le centre de la surface du bain 6. L'écoulement créé par ce mode de soufflage génère des boucles de recirculation 1A et 1B qui nuisent à l'efficacité de la protection souhaitée pour plusieurs raisons. D'une part, ces boucles 1A, 1B ont pour effet d'aspirer par les côtés de l'atmosphère extérieur (comme représenté par les flèches 2A et 2B) vers l'intérieur du moule. D'autre part, une partie du flux remontant d'argon ayant déjà léché une première fois la surface du bain et contenant de ce fait des impuretés, est réinjecté vers le bas et lèche une deuxième fois la surface du bain (comme représenté par les flèches 3A et 3B). Enfin, la partie du flux remontant d'argon qui est réinjectée vers le bas constitue un vecteur pour transporter des impuretés présentes dans l'environnement du bain 6, issues par exemple des parois du four. En définitive, la circulation du flux gazeux balayant la surface libre du matériau à traiter est mal maîtrisée.

On connaît des documents CN201971920U, GB2490130A, DE102013203113A1 et EP1048758 différents systèmes et procédés destinés à la production de silicium.

La présente invention vient améliorer la situation.

A cet effet, l'invention concerne un procédé de traitement comme décrit dans la revendication 1.

Grâce à l'invention, le deuxième flux s'évacuant à travers la partie supérieure de la zone d'évacuation crée une aspiration qui garantit une bonne évacuation du premier flux et évite par exemple la formation de boucles de recirculation. Le deuxième flux agit non seulement pour protéger le matériau de l'environnement autour du récipient mais également pour aider à l'évacuation directe du premier flux remontant après un premier et unique balayage de la surface libre du matériau.

Le premier flux gazeux peut jouer un rôle de purification de la surface libre du matériau. On peut également envisager que ce premier flux joue un rôle autre que la purification. Par exemple, il pourrait par exemple s'agir d'un gaz, ou d'un mélange de gaz, réactif vis-à-vis du matériau liquide à traiter.

Dans un mode de réalisation particulier, le matériau étant contenu dans un récipient pourvu d'au moins une ouverture d'évacuation, le deuxième flux est évacué à travers une partie supérieure de ladite ouverture d'évacuation et le premier flux est évacué à travers une partie inférieure restante de l'ouverture d'évacuation.

Dans un mode de réalisation particulier, un nombre N de deuxièmes flux gazeux est émis puis évacué respectivement à travers N ouvertures d'évacuation du récipient, N étant supérieur ou égal à deux, notamment égal à quatre.

Dans ce cas, les deuxièmes flux sont diffusés de manière à couvrir les différentes ouvertures d'évacuation du récipient.

Avantageusement, un ensemble de premiers flux est émis, ledit ensemble comportant un flux central dirigé verticalement vers le bas et une pluralité de flux latéraux orientés respectivement vers une pluralité de zones périphériques de la surface libre du matériau. Grâce à cela, la surface libre du matériau liquide est mieux couverte par les premiers flux.

Dans un mode de réalisation particulier, le deuxième flux est dimensionné pour couvrir la largeur horizontale de ladite ouverture d'évacuation. Grâce à cela, l'aspiration créée par le deuxième flux est optimale.

Avantageusement, le premier flux central est émis depuis une zone d'émission positionnée au-dessous de l'ouverture d'évacuation.

Grâce à cela, le premier flux ne risque pas d'être évacué vers l'extérieur du récipient avant d'avoir balayé la surface libre du matériau.

Avantageusement encore, les premier et deuxième flux sont émis depuis des zones d'émission situées sur ou à proximité d'un axe central vertical du récipient.

Ainsi, les flux sont diffusés de façon optimale et homogène dans le récipient.

Selon des modes de réalisation particuliers :
- ladite partie supérieure de l'ouverture d'évacuation occupe jusqu'à 50-70% de la hauteur totale de l'ouverture, notamment ;
- les premiers flux latéraux sont dirigés selon une direction formant un angle compris strictement entre 0° et 90° par rapport à la verticale, notamment inférieur ou égal à 45° ;
- le premier flux est un flux de purification de la surface libre du matériau, comprenant un gaz, ou un mélange de gaz, inerte vis-à-vis du matériau à traiter;
- l'étape de balayage de la surface libre du matériau est mise en oeuvre durant une opération de cristallisation du matériau.

L'invention concerne également un dispositif de traitement d'une surface libre d'un matériau, comprenant des éléments matériels adaptés pour mettre en oeuvre les étapes du procédé précédemment défini.

L'invention concerne encore un système comportant un dispositif de traitement de surface libre comme définit par la revendication 11.

Avantageusement, le dispositif comprend N ouvertures latérales d'émission de N deuxièmes flux gazeux respectifs, N étant supérieur ou égal à deux, notamment égal à quatre.

Avantageusement, la collerette ménage une pluralité de fentes verticales, chaque fente comportant un fond incliné par rapport à la verticale et formant une rampe d'écoulement d'un premier flux latéral, ladite rampe étant adaptée pour orienter le premier flux vers une pluralité de zones d'une ou des parois latérales du récipient.

Dans une forme de réalisation particulière, ladite ouverture latérale d'émission d'un deuxième flux est dimensionnée de manière à assurer une répartition d'un flux gazeux d'alimentation en au moins un deuxième flux et au moins un premier flux selon des proportions prédéfinies.

Avantageusement, ledit récipient est dépourvu de couvercle.

Le ou les deuxièmes flux forment une couche de gaz espacée de la surface libre du matériau et s'étendant au-dessus de celle-ci en la recouvrant. Cette couche de gaz constitue en définitive un couvercle gazeux de protection. Le couvercle physique du récipient peut ainsi être supprimé. La suppression du couvercle physique permet, d'une part, de remplir plus facilement le récipient avec des charges solides de matériau et, d'autre part, d'obtenir un gain de place pour charger le récipient avec des charges de matériau solide en morceaux, avant fusion de celles-ci.

L'invention sera mieux comprise à l'aide de la description suivante d'un mode de réalisation particulier du procédé de traitement de la surface libre d'un matériau et d'un exemple de réalisation particulier d'un dispositif de traitement associé, dans le cadre d'une application particulière de l'invention à la cristallisation d'un matériau, en référence aux dessins annexés sur lesquels :
- la figure 2 représente une vue générale de différents types de flux gazeux de traitement de la surface libre d'un matériau liquide ;
- la figure 3 représente une vue schématique d'un dispositif de traitement monté dans un récipient, au-dessus de la surface libre d'un matériau liquide contenu dans le récipient, selon un exemple de réalisation particulier, le dispositif représenté étant adapté pour produire les flux de la figure 2 ;
- les figures 4A et 4B représentent respectivement une vue de dessus de la couverture horizontale d'un flux de protection produit par le dispositif de la figure 3 et une vue latérale de la couverture verticale de ce flux de protection;

- la figure 5 représente une vue 3D, partiellement en transparence, du dispositif de traitement de la figure 3 ;
- les figures 6A, 6B et 6C représentent respectivement une vue de côté, une vue en coupe AA et une vue de dessous d'une partie inférieure d'un conduit du dispositif de traitement ;
- les figures 7A et 7B représentent deux vues en coupes, décalées de 90°, du bas d'une partie supérieure et du haut de a partie inférieure du conduit du dispositif de traitement ;
- la figure 8 représente une vue 3D, partiellement en transparence, du dispositif de traitement de la figure 3 et montre la répartition de différents types de flux gazeux émis ;
- la figure 9 représente un organigramme des étapes du procédé de traitement, selon un mode de réalisation particulier de l'invention.

Sur la figure 2, on a représenté schématiquement un récipient 10 contenant un matériau liquide 15, ce récipient étant placé dans l'enceinte d'un four. Les flèches 11-14 apparaissant sur cette figure correspondent à des flux gazeux et permettent d'illustrer le principe de l'invention. Les flux gazeux 12, 13, issus d'un ou plusieurs flux d'alimentation 11, coopèrent pour traiter la surface libre du matériau liquide 15, comme cela sera explicité de façon détaillée plus loin. Les flux 14 correspondent à des écoulements de gaz autour du récipient 10, dans l'enceinte du four.

Par définition, un « flux gazeux » désigne l'écoulement d'un gaz formé par le gaz émis à travers une ouverture. Un conduit, ou un embout de conduit, présentant N ouvertures d'émission est donc adapté pour émettre N flux de gaz, formés respectivement par les N ouvertures.

Dans l'exemple particulier de la description, le traitement selon l'invention est décrit dans le cas d'une application particulière à la cristallisation de silicium. Le matériau 15 est du silicium liquide, en fusion, et le récipient 10 est un creuset destiné à la fabrication d'un lingot de silicium.

Un repère tridimensionnel (x, y, z) et orthogonal est représenté sur les différentes figures, les axes x, y correspondant à un plan horizontal et l'axe z correspondant à la verticale.

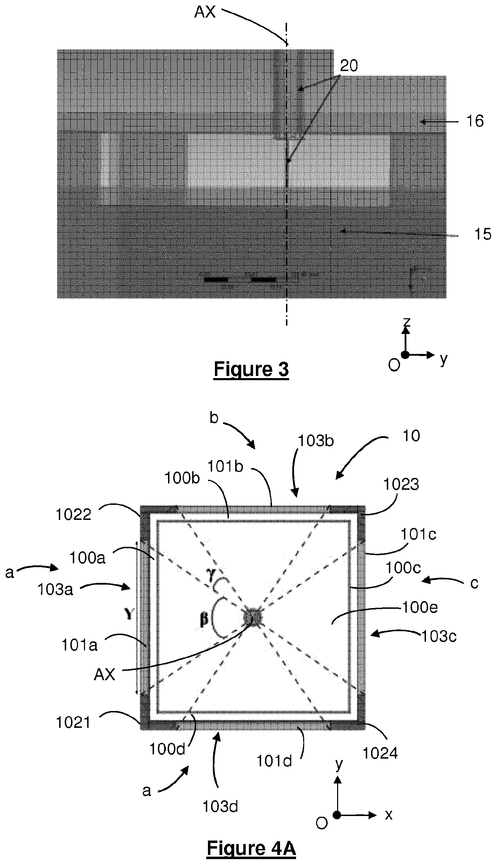

La figure 4A représente une vue de dessus du creuset 10 selon un exemple de réalisation particulier. Le creuset 10 a une forme de parallélépipède de section carrée et d'axe central longitudinal AX, vertical. Le creuset 10 est ouvert sur le dessus pour permettre son alimentation en charges solides de silicium. Il comprend des parois latérales internes 100a-100d et un fond 100e, réalisés en silice.

La silice devenant molle à des températures élevées (typiquement supérieures des températures de l'ordre de 1200°C), des pièces de contre-creuset en graphite dense entourent au moins partiellement les parois latérales 100a-100d. Le contre-creuset comprend des éléments latéraux externes 101a-101d de renfort de la résistance mécanique du creuset 10, et quatre coins surélevés 1021-1024 montant plus haut que les parois latérales 100a-100d en silice. La hauteur totale du creuset 10 est par exemple de l'ordre de 40 cm. Le silicium liquide contenu dans le creuset atteint généralement une hauteur d'environ 20 à 30 cm. La surface libre du silicium s'étend donc 10 à 20 cm plus bas que le haut des parois 100a-100d du creuset 10.

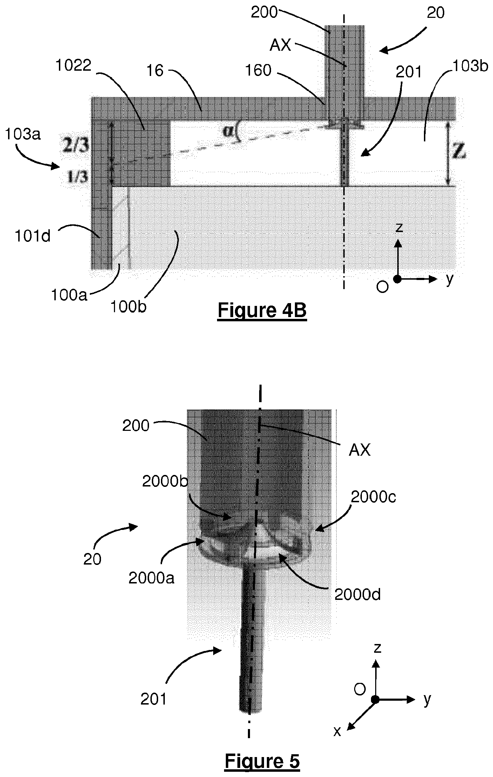

Un couvercle 16 repose sur les coins surélevés 1021-1024. Quatre ouvertures latérales d'évacuation 103a-103d sont ainsi formées entre le couvercle 16, les parois latérales renforcées 100a-100d et les coins surélevés 1021-1024. Chaque ouverture d'évacuation 103a (103b-103d) est ainsi délimitée en bas par le bord supérieur d'une paroi latérale en silice 100a (100b-100d) renforcée, latéralement par deux coins surélevés voisins 1021-1022 (1022-1023, 1023-1024, 1024-1021) et en haut par le couvercle 16. Chaque ouverture d'évacuation a une largeur horizontale Y (figure 4A) et une hauteur Z (figure 4B). La valeur de Z peut être de l'ordre de quelques centimètres, par exemple 6 cm, et la valeur de Y peut être de l'ordre d'une à plusieurs dizaines de centimètres, par exemple environ 30 cm.

En variante, le récipient 10 pourrait avoir une forme différente, par exemple cylindrique, et ménager un nombre N d'ouverture(s) d'évacuation latérale(s) différent de quatre, N étant supérieur ou égal à un.

Lors de la cristallisation du silicium dans le creuset 10, placé dans un four, pour la fabrication d'un lingot de silicium, la surface libre du silicium liquide en fusion est traitée par des flux de gaz, par exemple de l'Argon. Toutefois, on pourrait envisager l'utilisation d'un autre gaz vecteur adapté et en particulier un gaz ou un mélange de gaz inertes vis-à-vis du matériau liquide à traiter, tel que par exemple de l'Hélium ou du Néon. Le traitement vise, d'une part, à évaporer les vapeurs d'oxygène et le gaz d'oxyde de silicium présents à la surface du silicium en fusion et, d'autre part, à protéger la surface libre du silicium liquide de l'environnement «extérieur» du creuset 10, c'est-à-dire de l'atmosphère à l'intérieur du four.

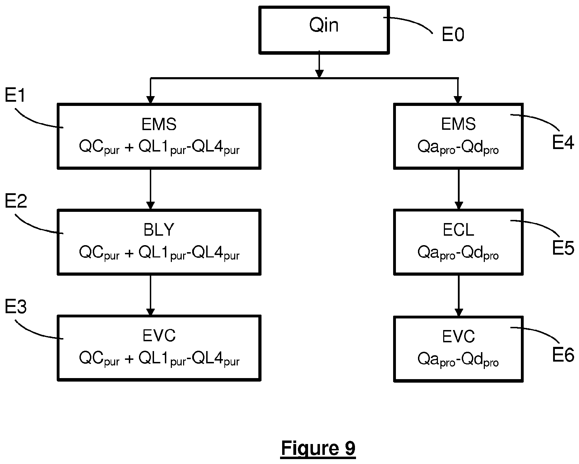

En référence à la figure 9, le procédé de traitement de la surface libre du silicium liquide contenu dans le creuset 10 va maintenant être décrit.

Sur la figure 2, on a représenté de façon schématique les phénomènes d'écoulement de flux gazeux dans et autour du creuset 10 se produisant lors d'un traitement de la surface libre du silicium liquide 15. Sont ainsi représentés :
- des écoulements 12 correspondant à des flux de purification QCₚᵤᵣ et QL1ₚᵤᵣ- QL4ₚᵤᵣ,
- des écoulements 13 correspondant à des flux de protection Qaₚᵣₒ-Qdₚᵣₒ et
- des écoulements 14 correspondant à des gaz circulant autour du creuset 10, dans l'enceinte du four.

Le procédé de traitement comprend une étape E0 d'alimentation en gaz, ici de l'argon, consistant à alimenter le creuset 10 avec un flux d'argon depuis un réservoir, non représenté. Dans l'exemple particulier décrit ici, l'étape E0 consiste à amener un flux d'alimentation d'argon, noté Qin, jusqu'à un dispositif d'émission et de répartition de flux gazeux dans le creuset 10. Cette étape d'alimentation est mise en oeuvre en continu tout au long du traitement de la surface libre du silicium, pendant la fabrication d'un lingot. On pourrait envisager d'alimenter le récipient avec plusieurs flux d'argon.

Le procédé comprend ensuite une étape E1 d'émission ici d'une pluralité de flux gazeux de purification. Les flux de purification émis comprennent :
- un flux central vertical dirigé vers le bas, noté QCₚᵤᵣ, et
- ici quatre flux latéraux obliques, notés QL1ₚᵤᵣ-QL4ₚᵤᵣ dirigés globalement vers le bas et orientés de manière oblique vers quatre zones cibles de la surface libre de silicium, ces zones cibles étant respectivement situées à proximité des quatre coins internes du creuset 10.

Les flux de purification sont émis depuis des zones d'émission centrales situées sur l'axe AX ou à proximité de celui-ci (à une distance de l'axe AX comprise entre 0 et un, voire quelques centimètres), au-dessus du bain de silicium 15.

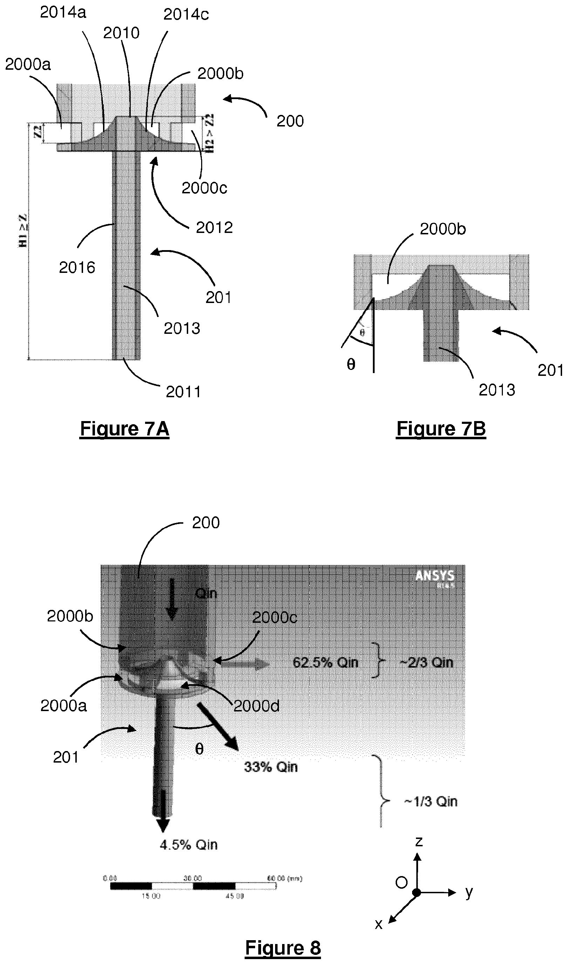

La direction des flux latéraux obliques QL1ₚᵤᵣ- QL4ₚᵤᵣ forme un angle θ (représenté en figure 8) d'inclinaison par rapport à la verticale. Cet angle θ est ici compris strictement entre 0° et 90°, de préférencesupérieur strictement à 0° et inférieur ou égal à 45°.

La zone d'émission du flux central QCₚᵤᵣ est décalée vers le bas par rapport aux zones d'émission des flux latéraux QL1ₚᵤᵣ-QL4ₚᵤᵣ. En l'espèce, la zone d'émission du flux central QCₚᵤᵣ est située légèrement au-dessous du plan d'ouverture supérieure du moule en silice formé par les parois 100a-100d (ou par les parois 101a-101d dans le cas où les parois du contre-creuset en graphite sont plus hautes que le creuset en silice), alors que les zones d'émission des flux latéraux QL1ₚᵤᵣ- QL4ₚᵤᵣ sont situées légèrement sous le couvercle 16.

Le procédé comprend ensuite une étape de balayage E2 lors de laquelle les flux de purification émis viennent lécher, ou balayer, la surface libre du silicium liquide 15. L'association des différents types de flux de purification, à savoir le flux central QCₚᵤᵣ et les flux latéraux QL1ₚᵤᵣ- QL4ₚᵤᵣ, assure un balayage de la totalité de la surface libre de silicium liquide 15. Cette étape de balayage est mise en oeuvre pendant durant la cristallisation du silicium 15.

Après avoir balayé la surface libre du silicium, les flux de purification remontent le long des parois latérales du creuset 10 et sont évacués par les ouvertures d'évacuation 103a-103d, lors d'une étape E3.

Le procédé comprend également une étape E4 d'émission d'au moins un flux d'argon de protection. Dans l'exemple particulier décrit en l'espèce, quatre flux de protection Qaₚᵣₒ-Qdₚᵣₒ sont émis depuis des zones d'émission situées à proximité de l'axe central AX, légèrement sous le couvercle 16. Cette étape d'émission E4 est exécutée de façon concomitante avec l'étape E1 d'émission des flux de purification. Ainsi, les flux de purification QCₚᵤᵣ et QL1ₚᵤᵣ- QL4ₚᵤᵣ et les flux de protection Qaₚᵣₒ-Qdₚᵣₒ sont émis en même temps.

Lors d'une étape suivante E5, les flux gazeux de protection Qaₚᵣₒ-Qdₚᵣₒ émis s'écoulent au-dessus du silicium liquide de manière à former une couche de gaz s'étalant au-dessus du silicium 15 et espacée de la surface libre de celui-ci par un intervalle de distance non nul. Cette couche de gaz forme une barrière de protection et constitue en définitive un couvercle gazeux, positionné au-dessus des flux de purification QCₚᵤᵣ et QL1ₚᵤᵣ- QL4ₚᵤᵣ. Ainsi, les flux de purification sont intercalés (au moins en partie) entre les flux de protection Qaₚᵣₒ-Qdₚᵣₒ et la surface libre du bain de silicium 15.

Ensuite, lors d'une étape E6, les quatre flux de protection Qaₚᵣₒ-Qdₚᵣₒ sont évacués vers l'extérieur du creuset 10. Chaque flux de protection Qaₚᵣₒ (Qbₚᵣₒ - Qdₚᵣₒ) est évacué par une partie supérieure de l'ouverture d'évacuation correspondante 103a (103b-103d) du récipient 10.

Sur la figure 4A, on a représenté la couverture horizontale (c'est-à-dire dans un plan horizontal) des flux de protection Qaₚᵣₒ-Qdₚᵣₒ. Prenons l'exemple du flux Qaₚᵣₒ. Ce flux Qaₚᵣₒ est diffusé depuis une zone d'émission située à proximité de l'axe AX vers l'ouverture 103a, la largeur du flux Qaₚᵣₒ parallèlement au côté a du creuset 10 augmentant en direction de l'ouverture 103a. La largeur du flux Qaₚᵣₒ lorsqu'il atteint l'ouverture 103a est égale ou sensiblement égale à la largeur Y de l'ouverture 103a. Ainsi, horizontalement, le flux Qaₚᵣₒ couvre la totalité de la largeur Y de l'ouverture 103a. L'angle β d'ouverture du flux Qaₚᵣₒ est ici compris entre 60° et 90°, selon la taille du ceuset 10. La couverture horizontale des autres flux Qbₚᵣₒ-Qdₚᵣₒ, respectivement associés aux ouvertures 103b-103d, est analogue à celle du flux Qaₚᵣₒ. Sur la figure 4A, l'angle γ représente l'angle de parties en coin du creuset non couvertes par les flux de protection. Cet angle γ varie entre 0 et 30° environ. La somme des angles β et γ est ici égale à 90°.

Sur la figure 4B, on a représenté la couverture verticale (selon z) du flux de protection Qaₚᵣₒ. Dans l'exemple particulier représenté sur cette figure, le flux de protection Qaₚᵣₒ est diffusé depuis une zone d'émission située à proximité de l'axe AX, légèrement au-dessous du couvercle 16. Il s'écoule en direction de l'ouverture 103a, dessous et le long du couvercle 16, en s'élargissant vers le bas (selon z) selon un angle a, puis s'évacue du creuset 10 à travers une partie supérieure de l'ouverture 103a. Cette partie supérieure correspond par exemple au 2/3 de la hauteur totale de l'ouverture d'évacuation 103a. En variante, la partie supérieure de l'ouverture d'évacuation 103a couverte par le flux de protection Qaₚᵣₒ pourrait occuper jusqu'à 80% de la hauteur totale de cette ouverture 103a préférentiellement entre 50% et 70%. L'angle a est défini par le plan horizontal sur lequel le couvercle 16 s'étend et le plan de limite inférieure du flux Qaₚᵣₒ. La valeur de cet angle α dépend de la taille du creuset 10 et de la hauteur de l'ouverture d'évacuation 103a. Elle est typiquement non nulle et inférieure ou égale à 25° pour des dimensions usueles de creuset et d'ouvertures d'évacuation. La couverture verticale des autres flux Qbₚᵣₒ-Qdₚᵣₒ, respectivement associés aux ouvertures 103b-103d, est analogue à celle du flux Qaₚᵣₒ.

Notons que le flux de purification central vertical QCₚᵤᵣ est émis depuis une zone d'émission située au-dessous du plan contenant les bords inférieurs des ouvertures d'évacuation 103a-103d du creuset, afin d'éviter une évacuation du flux avant balayage de la surface libre du bain de silicium.

Les flux de purification QCₚᵤᵣ et QL1ₚᵤᵣ- QL4ₚᵤᵣ assurent un rôle de purification de l'intérieur du creuset 10, et notamment de la surface libre du silicium par balayage de celle-ci. Ils viennent lécher - ou balayer - la surface libre du bain de silicium puis remontent latéralement, le long des parois latérales internes du creuset 10, et enfin sont évacués vers l'extérieur du creuset 10 par les ouvertures d'évacuation 103a-103d. La circulation de ces flux de purification QCₚᵤᵣ et QL1ₚᵤᵣ- QL4ₚᵤᵣ est représentée de façon schématique sur la figure 2 par la référence 12. Ils nettoient la surface libre du silicium liquide 15, en agissant sur une couche s'étendant au-dessus du bain de silicium. Ils favorisent également l'évaporation d'oxygène et de gaz d'oxyde de silicium, ce qui a pour effet de diminuer la quantité d'oxygène dans le lingot fabriqué.

Les flux de protection Qaₚᵣₒ-Qdₚᵣₒ assurent un rôle de barrière de protection de la surface libre du bain de silicium contre les gaz et impuretés circulant dans l'enceinte du four. Ils empêchent ces gaz et impuretés, présents dans l'atmosphère environnant le creuset, d'atteindre la surface libre du silicium liquide et de polluer le lingot.

En outre, les flux de protection Qaₚᵣₒ-Qdₚᵣₒ, en s'évacuant vers l'extérieur du creuset 10 par la partie supérieure des ouvertures d'évacuation 103a-103d, coopèrent avec les flux de purification QCₚᵤᵣ et QL1ₚᵤᵣ- QL4ₚᵤᵣ pour :
- contribuer à l'évacuation vers l'extérieur, à travers la partie inférieure restante des ouvertures d'évacuation 103a-103d, des flux de purification flux QCₚᵤᵣ et QL1ₚᵤᵣ- QL4ₚᵤᵣ qui remontent après avoir balayé une première et unique fois la surface libre de silicium 103a-103d, et
- entraver la formation de boucles de recirculation.

Cette synergie entre les deux types de flux (protection et purification) s'explique par le fait que les flux de protection Qaₚᵣₒ-Qdₚᵣₒ, en s'évacuant par la partie supérieure des ouvertures d'évacuation 103a-103d, créent, par effet venturi, un phénomène d'aspiration, que l'on peut également qualifier d'effet de pompe, en attirant vers l'extérieur du creuset 10 les flux remontants de purification flux QCₚᵤᵣ et QL1ₚᵤᵣ- QL4ₚᵤᵣ. Autrement dit, les flux de protection Qaₚᵣₒ-Qdₚᵣₒ produisent une aspiration (ou pompe) qui aide et contraint l'intégralité des flux de protection remontants à s'évacuer directement vers l'extérieur du creuset 10, sans qu'une partie de ces flux ne repartent vers l'intérieur du creuset 10.

Le procédé de traitement selon l'invention permet de purifier efficacement la surface libre du bain de silicium et d'éviter notamment toute pollution en carbone et oxygène du silicium. Le lingot de silicium fabriqué est ainsi exempt de contamination de ce type.

On va maintenant décrire un exemple de réalisation particulier, non limitatif, d'un dispositif de traitement 20 adapté pour mettre en oeuvre le procédé qui vient d'être décrit.

Notons que le procédé pourrait être mis en oeuvre par d'autres formes de réalisation du dispositif de traitement comprenant des éléments matériels adaptés pour mettre en oeuvre les étapes du procédé qui vient d'être décrit.

Le dispositif de traitement est adapté pour répartir un flux d'argon entrant, Qin, en différents flux de purification QCₚᵤᵣ et QL1ₚᵤᵣ- QL4ₚᵤᵣ et de protection Qaₚᵣₒ-Qdₚᵣₒ et pour diffuser ces flux dans le but de traiter la surface libre du silicium liquide 15 contenu dans le creuset 10 lors de la fabrication d'un lingot de silicium.

Le dispositif comprend un conduit 20 d'émission de flux gazeux s'étendant le long de l'axe vertical AX qui forme un axe de symétrie du conduit 20. Le conduit d'émission comprend ici une partie supérieure 200 et une partie inférieure 201, raccordées l'une à l'autre. Par la suite, on appellera « conduit supérieur », la partie supérieure 200 du conduit d'émission 20, et « conduit inférieur », la partie inférieure 201 du conduit d'émission 20.

En variante, le conduit pourrait être fabriqué en une seule pièce.

Le conduit supérieur 200, de forme cylindrique, est relié par un conduit d'alimentation (non représenté) à un réservoir d'alimentation en argon (non représenté). La portion d'extrémité inférieure du conduit 200 est ouverte vers le bas par une ouverture de raccordement au conduit inférieur 201 et ménage ici quatre ouvertures latérales d'émission 2000a-2000d telles que représentées sur la figure 5.

Les ouvertures latérales d'émission 2000a-2000d sont constituées par des fentes à bords droits allongées horizontalement. Elles sont toutes de mêmes dimensions et réparties de façon régulière sur le pourtour du conduit 200. Chaque ouverture 2000a-2000d s'étend, dans un plan horizontal, le long d'un arc de cercle défini par un angle δ (non représenté). Cet angle δ est formé par les deux demi-droites partant de l'axe AX et passant par les extrémités latérales de l'ouverture dans un plan horizontal. Il est égal à l'angle β précédemment mentionné et donc compris entre 60° et 90°. La hauteur des ouvertures 2000a-2000d, notée Z2, est comprise ici entre 0 et 5 cm. Ces ouvertures latérales 2000a-2000d ont pour rôle d'émettre les quatre flux de protection Qaₚᵣₒ-Qdₚᵣₒ, respectivement, comme cela sera explicité plus loin.

Le conduit inférieur 201 comprend un embout d'extrémité inférieure 2016, constituant une canne de soufflage, surmonté d'une collerette supérieure 2012. L'ensemble est traversé par un canal central interne 2013 de passage d'un gaz, de forme cylindrique et d'axe longitudinal AX. Ce canal 2013 relie une ouverture supérieure 2010 d'entrée de gaz et une ouverture inférieure 2011 de sortie ou d'émission de gaz. En fonctionnement, l'ouverture d'entrée 2010 prélève une partie du flux de gaz alimentant le dispositif 20 afin de produire le flux de purification central de purification QCₚᵤᵣ qui est émis vers le bas par l'ouverture inférieure de sortie 2011. Le canal 2013 est plus étroit que l'intérieur du conduit supérieur 200. Par exemple, le rayon du canal inférieur 2013 et le rayon interne du conduit supérieur 200 peuvent être compris respectivement entre 2 mm et 10 mm et entre 10 mm et 30 mm.

La collerette 2012 a un profil qui s'évase depuis l'ouverture d'entrée 2010 vers le bas, le dessous de la collerette 2012 s'étendant dans un plan horizontal. La hauteur H2 de la collerette 2012 est strictement supérieure à la hauteur Z2 des ouvertures d'émission 2000a-2000d et adaptée de manière à ce que l'ouverture d'entrée 2010 soit située au-dessus des ouvertures d'émission 2000a-2000d du conduit supérieur 200, comme représenté sur la figure 7A.

Le dessus de la collerette 2012 comprend ici quatre rampes 2014a-2014d d'écoulement et de guidage des flux de protection Qaₚᵣₒ-Qdₚᵣₒ, de mêmes formes et de mêmes dimensions. Les surfaces supérieures de ces rampes sont ici courbes, en forme de « toboggan », et dirigées vers le bas. L'inclinaison du bas de la rampe est égale à l'angle a, lequel détermine la couverture verticale des flux de protection Qaₚᵣₒ-Qdₚᵣₒ. L'étendue radiale de chaque rampe 2014a-2014d est définie par l'angle correspondant à l'angle des ouvertures latérales d'émission 2000a-2000d du conduit supérieur 20 (cet angle étant égal à l'angle β de couverture radiale d'un flux de protection). Les rampes 2014a-2014d sont ainsi conformées pour orienter les flux gazeux de protection vers la partie supérieure des ouvertures d'évacuation 103a-103d du creuset 10.

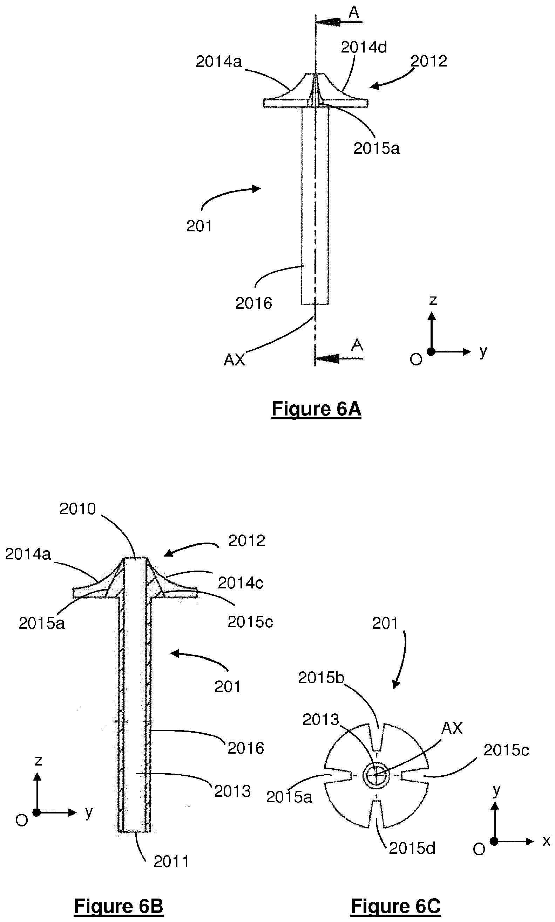

En référence aux figures 6A à 6C, les quatre rampes 2014a-2014d sont séparées l'une de l'autre par des fentes radiales verticales 2015a-2015d, ménagées dans la collerette 2012. L'angle d'ouverture de chaque fente est l'angle γ (figure 4A). On pourrait également envisager des ouvertures verticales 2015a-2015d sous forme d'encoches de largeur constante, l'angle étant nul dans ce cas. Le fond de chaque fente 2015a-2015d s'étend dans un plan incliné selon l'angle θ par rapport à la verticale et constitue une rampe d'écoulement d'un flux de purification latérale. L'inclinaison du fond de la fente permet d'orienter le flux d'argon dans la direction θ ici vers les zones des coins du creuset 10, comme précédemment explicité. Ces fentes 2015a-2015d constituent ainsi des canaux d'expulsion des flux de purification latéraux QL1ₚᵤᵣ- QL4ₚᵤᵣ.

En référence à la figure 7A, la hauteur H1 telle que représentée sur la figure 7A, entre l'ouverture inférieure 2011 du conduit 201 et le plan contenant les bords supérieurs des ouvertures d'émission 2000a-2000d, est supérieure ou égale à la hauteur Z des ouvertures d'évacuation 103a-103d du creuset 10. Ainsi, le flux de purification vertical est émis à partir d'une zone d'émission positionnée au-dessous des ouvertures d'évacuation 103a-103d du creuset 10.

Le conduit inférieur 21 est raccordé au conduit supérieur 20 par introduction de la collerette 2012 dans la portion d'extrémité inférieure du conduit supérieur 20, le dessous de la collerette 2012 s'étendant dans le plan de l'ouverture inférieure du conduit supérieur 20.

La fixation des deux conduits 200, 201 peut s'effectuer par vissage, des filetages étant dans ce cas réalisés dans le bas de la collerette 2012 et sur la paroi interne du conduit supérieur 20. Un élément de centrage, par exemple un écrou, est en outre prévu pour assurer un positionnement relatif des deux conduits 200 et 201. Ce positionnement doit garantir que les quatre ouvertures d'émission 2000a-2000d du conduit supérieur 200 soient placées au droit (au moins partiellement) des quatre rampes 2014a-2014d respectivement et que les bords inférieurs des ouvertures 2000a-2000d s'étendent dans le prolongement du bas des rampes 2014a-2014d.

Le dispositif de traitement est monté sur le couvercle 16, par introduction à travers une ouverture 160 ménagée dans le couvercle 16. Il est positionné de manière à ce que les ouvertures latérales d'émission 2000a-2000d, ménagées dans la portion d'extrémité basse du conduit supérieur 20, soient situées au-dessous du couvercle 16, par exemple à un distance comprise entre 0 et 1 cm au-dessous du couvercle 16.

L'ensemble comportant les ouvertures latérales d'émission 2000a-2000d du conduit supérieur 200, la collerette 2012 et la canne de soufflage 2016 forment un répartiteur agencé et conformé pour répartir un flux d'argon entrant Qin en différents flux, à savoir les flux de purification, central QCₚᵤᵣ et latéraux QL1ₚᵤᵣ- QL4ₚᵤᵣ, et les flux de protection Qaₚᵣₒ-Qdₚᵣₒ, selon des proportions respectives prédéfinies. Les dimensions des ouvertures latérales d'émission 2000a-2000d sont notamment adaptées pour assurer une répartition du flux d'argon entrant Qin entre les différents types de flux, à savoir le flux de purification vertical, les flux de purification latéraux et les flux de protection, selon des proportions prédéfinies.

Prenons l'exemple d'un dispositif de traitement présentant les dimensions (approximatives) suivantes :
- Y ≅ 31 cm ;
- Z ≅ 6 cm ;
- Z2 ≅ 0,5 cm ;
- α ≅ 6,5° ;
- β ≅ 73° ;
- γ ≅ 17°;
- θ ≅ 12°.

En outre, le creuset 10 est de format standard « G2 », de section carrée, et présente les dimensions suivantes :
- hauteur : 420mm
- largeur de chaque côté : 380mm.

En référence à la figure 8, avec de telles dimensions, le flux d'argon alimentant le dispositif, noté Qin, se répartit globalement de la manière suivante :
- les flux de protection Qaₚᵣₒ-Qdₚᵣₒ représentent environ 62,5% du flux Qin ;
- les flux de purification latéraux QL1ₚᵤᵣ- QL4ₚᵤᵣ représentent environ 33% du flux Qin ;
- le flux de purification QCₚᵤᵣ représente environ 4,5% du flux Qin.

Autrement dit, le flux d'argon Qin se répartit globalement : 2/3 en horizontal ou légèrement incliné par rapport à l'horizontal (Qaₚᵣₒ-Qdₚᵣₒ) et 1/3 dirigé vers le bas (QL1ₚᵤᵣ- QL4ₚᵤᵣ et QCₚᵤᵣ). Une telle répartition est optimale.

Dans l'exemple particulier de réalisation qui vient d'être décrit, les flux QCₚᵤᵣ et QL1ₚᵤᵣ- QL4ₚᵤᵣ, dits "premiers flux", ont une fonction de purification de la surface libre du matériau à traiter. Le traitement opéré par ces premiers flux consiste à purifier la surface libre du matériau. A cet effet, le gaz (ou le mélange gazeux) composant les premiers flux QCₚᵤᵣ et QL1ₚᵤᵣ- QL4ₚᵤᵣ est inerte vis-à-vis du matériau à traiter. Ces premiers flux pourraient en variante avoir une fonction de traitement de la surface libre du matériau, autre que la purification. Il pourrait s'agir de flux gazeux réactifs avec le matériau à traiter, la réaction entre les premiers flux et le matériau correspondant au traitement appliqué au matériau.

D'une façon générale, l'invention concerne donc un procédé de traitement de la surface libre d'un matériau liquide dans lequel
- un ou plusieurs premier(s) flux gazeux sont émis, balaient la surface libre du matériau liquide puis sont évacués par l'ouverture d'évacuation du récipient contenant le matériau à traiter, et
- concomitamment à l'émission du ou des premiers flux, un ou plusieurs deuxième(s) flux gazeux sont émis, de manière à former, au-dessus du matériau à traiter, un couvercle de protection espacé de la surface libre du matériau, puis sont évacués par une partie supérieure de l'ouverture d'évacuation du récipient, le ou les premier(s) flux étant évacués à travers la partie inférieure restante de l'ouverture d'évacuation.

Dans la description qui précède, les premiers flux et les deuxièmes flux comprennent le même gaz (ou mélange gazeux). En variante, il pourrait s'agir de deux gaz (ou mélanges gazeux) différents.

Au lieu de présenter une section carrée, le récipient 10 pourrait présenter toute autre forme. Par exemple, le récipient 10 pourrait être de forme cylindrique et présenter une section circulaire. Dans ce cas, les premiers flux (à savoir les flux de purification dans le cas de l'application de l'invention à la cristallisation d'un matériau) comportent un flux central dirigé verticalement vers le bas et une pluralité de flux latéraux orientés respectivement vers une pluralité de zones d'une ou des parois latérales du récipient.

Dans la description qui vient d'être faite, le récipient 10 est fermé par un couvercle 16. On pourrait envisager de supprimer le couvercle matériel, la couche de gaz formée par les flux de protection assurant la fonction de couvercle gazeux formant barrière de protection entre l'extérieur et l'intérieur du récipient. L'invention concerne donc aussi un système comportant le dispositif d'émission de flux et un récipient dépourvu de couvercle.

Dans la description qui précède, le récipient ménage des ouvertures d'évacuation des flux de traitement. On pourrait également envisager que les flux soient évacués par une zone d'évacuation surplombant le bord supérieur du récipient et s'étendant au-dessus de toute la périphérie de la surface libre à traiter du matériau. Dans ce cas, le ou les deuxièmes flux de traitement (à savoir les flux de protection dans l'exemple décrit) sont évacués par une partie supérieure de la zone d'évacuation et le ou les premiers flux de traitement (à savoir les flux de purification dans l'exemple décrit) sont évacués par une partie inférieure de la zone d'évacuation, intercalée entre la partie supérieure de la zone d'évacuation et le bord supérieur du récipient.

Le matériau à traiter pourrait être solide. Dans ce cas, il pourrait ne pas être contenu dans un récipient et la zone d'évacuation pourrait surplomber la périphérie de la surface libre du matériau.

## Revendications

1. Procédé de traitement d'une surface libre d'un matériau, comprenant une étape (E1) d'émission d'au moins un premier flux gazeux (QL1ₚᵤᵣ-QL4ₚᵤᵣ et QCₚᵤᵣ), une étape (E2) de balayage de la surface libre du matériau par le premier flux (QL1ₚᵤᵣ- QL4ₚᵤᵣ et QCₚᵤᵣ) suivie d'une étape (E3) d'évacuation du premier flux par au moins une zone d'évacuation (103a-103d), **caractérisé en ce qu'**il comprend, concomitamment à l'étape (E1) d'émission du premier flux (QL1ₚᵤᵣ- QL4ₚᵤᵣ et QCₚᵤᵣ), une étape (E4) d'émission d'au moins un deuxième flux gazeux (Qaₚᵣₒ-Qdₚᵣₒ) formant un couvercle de protection au-dessus de la surface libre du matériau (15), espacé de ladite surface libre, et une étape (E6) d'évacuation du deuxième flux gazeux (Qaₚᵣₒ-Qdₚᵣₒ) par une partie supérieure de ladite zone d'évacuation (103a-103d) d'un récipient (10), ledit premier flux (QL1ₚᵤᵣ- QL4ₚᵤᵣ et QCₚᵤᵣ) étant évacué à travers une partie inférieure de la zone d'évacuation (103a-103d), le matériau étant contenu dans un récipient pourvu d'au moins une ouverture d'évacuation, le deuxième flux étant évacué à travers une partie supérieure de ladite ouverture d'évacuation et le premier flux étant évacué à travers une partie inférieure restante de l'ouverture d'évacuation, ladite partie supérieure de l'ouverture d'évacuation (103a-103d) occupant entre 50% et 80% de la hauteur totale de l'ouverture (103a-103d).

2. Procédé selon la revendication 1, **caractérisé en ce qu'**un nombre N de deuxièmes flux gazeux (Qaₚᵣₒ-Qdₚᵣₒ) est émis puis évacué respectivement à travers N ouvertures d'évacuation (103a-103d) du récipient (10), N étant supérieur ou égal à deux, notamment égal à quatre.

3. Procédé selon l'une des revendications précédentes, **caractérisé en ce qu'**un ensemble de premiers flux (QL1ₚᵤᵣ- QL4ₚᵤᵣ et QCₚᵤᵣ) est émis, ledit ensemble comportant un flux central (QCₚᵤᵣ) dirigé verticalement vers le bas et une pluralité de flux latéraux (QL1ₚᵤᵣ- QL4ₚᵤᵣ) orientés respectivement vers une pluralité de zones périphériques de la surface libre du matériau.

4. Procédé selon l'une des revendications précédentes, **caractérisé en ce que** le deuxième flux (Qaₚᵣₒ-Qdₚᵣₒ) est dimensionné pour couvrir la largeur horizontale de ladite ouverture d'évacuation (103a-103d).

5. Procédé selon l'une des revendications 3 et 4, **caractérisé en ce que** le premier flux central (QCₚᵤᵣ) est émis depuis une zone d'émission positionnée au-dessous de l'ouverture d'évacuation (103a-103d).

6. Procédé selon l'une des revendications précédentes, **caractérisé en ce que** les premier et deuxième flux (QL1ₚᵤᵣ- QL4ₚᵤᵣ, QCₚᵤᵣ, Qaₚᵣₒ-Qdₚᵣₒ) sont émis depuis des zones d'émission situées sur ou à proximité d'un axe central vertical du récipient (10).

7. Procédé selon l'une des revendications précédentes, **caractérisé en ce que** ladite partie supérieure de l'ouverture d'évacuation (103a-103d) occupe entre 50% et 70% de ladite hauteur.

8. Procédé selon l'une des revendications 3 à 7, **caractérisé en ce que** les premiers flux latéraux (QL1ₚᵤᵣ- QL4ₚᵤᵣ) sont dirigés selon une direction formant un angle (θ) compris strictement entre 0° et 90° par rapport à la verticale, notamment inférieur ou égal à 45°.

9. Procédé selon l'une des revendications précédentes, **caractérisé en ce que** le premier flux (QL1ₚᵤᵣ- QL4ₚᵤᵣ, QCₚᵤᵣ) est un flux de purification de la surface libre du matériau (15), comprenant un gaz, ou un mélange de gaz, inerte vis-à-vis du matériau à traiter.

10. Procédé selon l'une des revendications précédentes, **caractérisé en ce que** l'étape (E2) de balayage de la surface libre du matériau est mise en oeuvre durant une opération de cristallisation du matériau (15).

11. Système comportant un dispositif de traitement d'une surface libre d'un matériau et un récipient (10) destiné à contenir le matériau à traiter, le dispositif comprenant un conduit (200-201) d'émission d'au moins un premier flux gazeux (QL1ₚᵤᵣ- QL4ₚᵤᵣ et QCₚᵤᵣ) adapté pour balayer la surface libre du matériau puis être évacué par au moins une zone d'évacuation (103a-103d), **caractérisé en ce que** le conduit d'émission (200-201) comprend au moins une ouverture latérale (2000a-2000d) d'émission d'un deuxième flux gazeux (Qaₚᵣₒ-Qdₚᵣₒ) adapté pour former un couvercle de protection au-dessus de la surface libre du matériau et espacé de ladite surface libre, et pour être évacué par une partie supérieure de la zone d'évacuation (103a-103d) d'un récipient (10), une partie inférieure de la zone d'évacuation (103a-103d) servant à l'évacuation du premier flux (QL1ₚᵤᵣ- QL4ₚᵤᵣ et QCₚᵤᵣ), le récipient étant pourvu d'au moins une ouverture d'évacuation du deuxième flux à travers une partie supérieure de ladite ouverture d'évacuation et du premier flux à travers une partie inférieure restante de l'ouverture d'évacuation, ladite partie supérieure de l'ouverture d'évacuation (103a-103d) occupant entre 50% et 80% de la hauteur totale de l'ouverture (103a-103d), le conduit (200-201) comprenant deux parties, supérieure (200) et inférieure (201), la section de la partie supérieure étant plus grande que celle de la partie inférieure, ladite ouverture latérale d'émission (2000a-2000d) étant ménagée dans la partie supérieure (200), la partie inférieure (201) comportant une collerette supérieure (2012) introduite dans la partie supérieure (200), ladite collerette présentant au moins une rampe (2014a-2014d) d'écoulement d'un deuxième flux (Qaₚᵣₒ-Qdₚᵣₒ) s'étendant au moins partiellement au droit de l'ouverture latérale d'émission (2000a-2000d), ladite rampe étant conformée pour orienter le deuxième flux vers la partie supérieure de la zone d'évacuation (103a-103d).

12. Système selon la revendication 11, **caractérisé en ce que** le dispositif comprend N ouvertures latérales (2000a-2000d) d'émission de N deuxièmes flux gazeux respectifs (Qaₚᵣₒ-Qdₚᵣₒ), N étant supérieur ou égal à deux, notamment égal à quatre.

13. Système selon la revendication 11 ou 12, **caractérisé en ce que** la collerette (2012) ménage une pluralité de fentes verticales (2015a-2015d), chaque fente comportant un fond incliné par rapport à la verticale et formant une rampe d'écoulement d'un premier flux latéral (QL1ₚᵤᵣ- QL4ₚᵤᵣ), ladite rampe étant adaptée pour orienter le premier flux latéral vers une pluralité de zones périphériques de la surface libre du matériau.

14. Système selon l'une des revendications 11 à 13, **caractérisé en ce que** ladite ouverture latérale (2000a-2000d) d'émission d'un deuxième flux (QL1ₚᵤᵣ- QL4ₚᵤᵣ) est dimensionnée de manière à assurer une répartition d'un flux gazeux d'alimentation en au moins un deuxième flux et au moins un premier flux selon des proportions prédéfinies.

15. Système selon l'une des revendications 11 à 14, **caractérisé en ce que** ladite partie supérieure de l'ouverture d'évacuation (103a-103d) occupe entre 50% et 70% de ladite hauteur.

## Patentansprüche

1. Verfahren zur Behandlung einer freien Oberfläche eines Materials, umfassend einen Schritt (E1) der Emission mindestens eines ersten Gasstroms (QL1ₚᵤᵣ-QL4ₚᵤᵣ und QCₚᵤᵣ), einen Schritt (E2) des Überstreichens der freien Oberfläche des Materials mit dem ersten Strom (QL1ₚᵤᵣ-QL4ₚᵤᵣ und QCₚᵤᵣ), gefolgt von einem Schritt (E3) der Abfuhr des ersten Stroms durch mindestens eine Abfuhrzone (103a-103d),
**dadurch gekennzeichnet, dass** dieses, gleichzeitig mit dem Schritt (E1) der Emission des ersten Stroms (QL1ₚᵤᵣ-QL4ₚᵤᵣ und QCₚᵤᵣ), einen Schritt (E4) der Emission mindestens eines zweiten Gasstroms (Qaₚᵣₒ-Qdₚᵣₒ), der eine Schutzhülle über der freien Oberfläche des Materials (15) bildet, die von der freien Oberfläche beabstandet ist, und einen Schritt (E6) der Abfuhr des zweiten Gasstroms (Qaₚᵣₒ-Qdₚᵣₒ) durch einen oberen Teil der Abfuhrzone (103a-103d) eines Behälters (10) umfasst, wobei der erste Strom (QL1ₚᵤᵣ-QL4ₚᵤᵣ und QCₚᵤᵣ) quer durch einen unteren Teil der Abfuhrzone (103a-103d) abgeführt wird, wobei das Material in einem Behälter enthalten ist, der mit mindestens einer Abfuhröffnung versehen ist, wobei der zweite Strom quer durch einen oberen Teil der Abfuhröffnung abgeführt wird, und der erste Strom quer durch einen übrigen unteren Teil der Abfuhröffnung abgeführt wird, wobei der obere Teil der Abfuhröffnung (103a-103d) zwischen 50 % und 80 % der Gesamthöhe der Öffnung (103a-103d) einnimmt.

2. Verfahren nach Anspruch 1,
**dadurch gekennzeichnet, dass** eine Anzahl N von zweiten Gasströmen (Qaₚᵣₒ-Qdₚᵣₒ) emittiert wird und dann abgeführt wird, jeweils quer durch N Abfuhröffnungen (103a-103d) des Behälters (10), wobei N größer oder gleich zwei ist, insbesondere gleich vier.

3. Verfahren nach einem der vorhergehenden Ansprüche,
**dadurch gekennzeichnet, dass** eine Gesamtheit erster Ströme (QL1ₚᵤᵣ-QL4ₚᵤᵣ und QCₚᵤᵣ) emittiert wird, wobei die Gesamtheit einen zentralen Strom (QCₚᵤᵣ), der vertikal nach unten gerichtet ist, und eine Vielzahl von seitlichen Strömen (QL1ₚᵤᵣ-QL4ₚᵤᵣ), die jeweils zu einer Vielzahl von peripheren Zonen der freien Oberfläche des Materials orientiert sind, umfasst.

4. Verfahren nach einem der vorhergehenden Ansprüche,
**dadurch gekennzeichnet, dass** der zweite Strom (Qaₚᵣₒ-Qdₚᵣₒ) bemessen ist, um die horizontale Breite der Abfuhröffnung (103a-103d) abzudecken.

5. Verfahren nach einem der Ansprüche 3 und 4,
**dadurch gekennzeichnet, dass** der erste zentrale Strom (QCₚᵤᵣ) aus einer Emissionszone emittiert wird, die unter der Abfuhröffnung (103a-103d) positioniert ist.

6. Verfahren nach einem der vorhergehenden Ansprüche,
**dadurch gekennzeichnet, dass** der erste und zweite Strom (QL1ₚᵤᵣ-QL4ₚᵤᵣ, QCₚᵤᵣ, Qaₚᵣₒ-Qdₚᵣₒ) aus Emissionszonen emittiert werden, die auf oder in der Nähe einer vertikalen zentralen Achse des Behälters (10) angeordnet sind.

7. Verfahren nach einem der vorhergehenden Ansprüche,
**dadurch gekennzeichnet, dass** der obere Teil der Abfuhröffnung (103a-103d) zwischen 50 % und 70 % der Höhe einnimmt.

8. Verfahren nach einem der Ansprüche 3 bis 7,
**dadurch gekennzeichnet, dass** die ersten seitlichen Ströme (QL1ₚᵤᵣ-QL4ₚᵤᵣ) in eine Richtung gerichtet sind, die einen Winkel (θ) streng zwischen 0° und 90° in Bezug auf die Vertikale bildet, insbesondere kleiner oder gleich 45°.

9. Verfahren nach einem der vorhergehenden Ansprüche,
**dadurch gekennzeichnet, dass** der erste Strom (QL1ₚᵤᵣ-QL4ₚᵤᵣ, QCₚᵤᵣ) ein Strom zur Reinigung der freien Oberfläche des Materials (15) ist, der ein Gas oder ein Gasgemisch, das gegenüber dem zu behandelnden Material inert ist, umfasst.

10. Verfahren nach einem der vorhergehenden Ansprüche,
**dadurch gekennzeichnet, dass** der Schritt (E2) des Überstreichens der freien Oberfläche des Materials während eines Kristallisationsvorgangs des Materials (15) durchgeführt wird.

11. System, umfassend eine Vorrichtung zur Behandlung einer freien Oberfläche eines Materials und einen Behälter (10), der dazu bestimmt ist, das zu behandelnde Material zu enthalten, wobei die Vorrichtung eine Leitung (200-201) zur Emission mindestens eines ersten Gasstroms (QL1ₚᵤᵣ-QL4ₚᵤᵣ und QCₚᵤᵣ) umfasst, der geeignet ist, die freie Oberfläche des Materials zu überstreichen, um dann durch mindestens eine Abfuhrzone (103a-103d) abgeführt zu werden,
**dadurch gekennzeichnet, dass** die Emissionsleitung (200-201) mindestens eine seitliche Öffnung (2000a-2000d) zur Emission eines zweiten Gasstroms (Qaₚᵣₒ-Qdₚᵣₒ) umfasst, der geeignet ist, eine Schutzhülle über der freien Oberfläche des Materials zu bilden, und die von der freien Oberfläche beabstandet ist, und um durch einen oberen Teil der Abfuhrzone (103a-103d) eines Behälters (10) abgeführt zu werden, wobei ein unterer Teil der Abfuhrzone (103a-103d) zur Abfuhr des ersten Stroms (QL1ₚᵤᵣ-QL4ₚᵤᵣ und QCₚᵤᵣ) dient, wobei der Behälter mit mindestens einer Abfuhröffnung des zweiten Stroms quer durch einen oberen Teil der Abfuhröffnung und des ersten Stroms quer durch einen übrigen unteren Teil der Abfuhröffnung versehen ist, wobei der obere Teil der Abfuhröffnung (103a-103d) zwischen 50 % und 80 % der Gesamthöhe der Öffnung (103a-103d) einnimmt, wobei die Leitung (200-201) zwei Teile, einen oberen (200) und einen unteren (201), umfasst, wobei der Querschnitt des oberen Teils größer ist als jener des unteren Teils, wobei die seitliche Emissionsöffnung (2000a-2000d) in dem oberen Teil (200) angeordnet ist, wobei der untere Teil (201) einen oberen Kragen (2012) umfasst, der in den oberen Teil (200) eingeführt wird, wobei der Kragen mindestens eine Abflussrampe (2014a-2014d) eines zweiten Gasstroms (Qaₚᵣₒ-Qdₚᵣₒ) umfasst, die sich mindestens teilweise rechts von der seitlichen Emissionsöffnung (2000a-2000d) erstreckt, wobei die Rampe angepasst ist, um den zweiten Strom zu dem oberen Teil der Abfuhrzone (103a-103d) zu orientieren.

12. System nach Anspruch 11,
**dadurch gekennzeichnet, dass** die Vorrichtung N seitliche Öffnungen (2000a-2000d) zur Emission von N jeweiligen zweiten Gasströmen (Qaₚᵣₒ-Qdₚᵣₒ) umfasst, wobei N größer oder gleich zwei ist, insbesondere gleich vier.

13. System nach Anspruch 11 oder 12,
**dadurch gekennzeichnet, dass** der Kragen (2012) eine Vielzahl von vertikalen Schlitzen (2015a-2015d) aufweist, wobei jeder Schlitz einen Boden umfasst, der in Bezug auf die Vertikale geneigt ist und eine Abflussrampe eines ersten seitlichen Stroms (QL1ₚᵤᵣ-QL4ₚᵤᵣ) bildet, wobei die Rampe geeignet ist, den ersten seitlichen Strom zu einer Vielzahl von peripheren Zonen der freien Oberfläche des Materials zu orientieren.

14. System nach einem der Ansprüche 11 bis 13,
**dadurch gekennzeichnet, dass** die seitliche Öffnung (2000a-2000d) zur Emission eines zweiten Stroms (QL1ₚᵤᵣ-QL4ₚᵤᵣ) bemessen ist, um eine Teilung eines Versorgungsgasstroms in mindestens einen zweiten Strom und mindestens einen ersten Strom gemäß vordefinierten Anteilen sicherzustellen.

15. System nach einem der Ansprüche 11 bis 14,
**dadurch gekennzeichnet, dass** der obere Teil der Abfuhröffnung (103a-103d) zwischen 50 % und 70 % der Höhe einnimmt.

## Claims

1. Method for treating a free surface of a material, comprising a step (E1) of emission of at least one first gas flow (QL1ₚᵤᵣ-QL4ₚᵤᵣ and QCₚᵤᵣ), a step (E2) of sweeping of the free surface of the material by the first flow (QL1ₚᵤᵣ-QL4ₚᵤᵣ and QCₚᵤᵣ) followed by a step (E3) of evacuation of the first flow by at least one evacuation zone (103a-103d), **characterized in that** it comprises, concomitantly with the step (E1) of emission of the first flow (QL1ₚᵤᵣ-QL4ₚᵤᵣ and QCₚᵤᵣ), a step (E4) of emission of at least one second gas flow (Qaₚᵣₒ-Qdₚᵣₒ) forming a protective cover above the free surface of the material (15), spaced apart from said free surface, and a step (E6) of evacuation of the second gas flow (Qaₚᵣₒ-Qdₚᵣₒ) by an upper part of said evacuation zone (103a-103d) of a container (10), said first flow (QL1ₚᵤᵣ-QL4ₚᵤᵣ and QCₚᵤᵣ) being evacuated through a lower part of the evacuation zone (103a-103d), the material being contained in a container provided with at least one evacuation aperture, the second flow being evacuated through an upper part of said evacuation aperture and the first flow being evacuated through a remaining lower part of the evacuation aperture, said upper part of the evacuation aperture (103a-103d) occupying between 50% and 80% of the total height of the aperture (103a-103d) .

2. Method according to Claim 1, **characterized in that** a number N of second gas flows (Qaₚᵣₒ-Qdₚᵣₒ) is emitted then evacuated respectively through N evacuation apertures (103a-103d) of the container (10), N being greater than or equal to two, notably equal to four.

3. Method according to one of the preceding claims, **characterized in that** a set of first flows (QL1ₚᵤᵣ-QL4ₚᵤᵣ and QCₚᵤᵣ) is emitted, said set comprising a central flow (QCₚᵤᵣ) directed vertically downwards and a plurality of lateral flows (QL1ₚᵤᵣ- QL4ₚᵤᵣ) oriented respectively towards a plurality of peripheral zones of the free surface of the material.

4. Method according to one of the preceding claims, **characterized in that** the second flow (Qaₚᵣₒ-Qdₚᵣₒ) is dimensioned to cover the horizontal width of said evacuation aperture (103a-103d).

5. Method according to one of Claims 3 and 4, **characterized in that** the first central flow (QCₚᵤᵣ) is emitted from an emission zone positioned below the evacuation aperture (103a-103d).

6. Method according to one of the preceding claims, **characterized in that** the first and the second flows (QL1ₚᵤᵣ- QL4ₚᵤᵣ, QCₚᵤᵣ, Qaₚᵣₒ-QDₚᵣₒ) are emitted from emission zones situated on or in proximity to a vertical central axis of the container (10).

7. Method according to one of the preceding claims, **characterized in that** said upper part of the evacuation aperture (103a-103d) occupies between 50% and 70% of said height.

8. Method according to one of Claims 3 to 7, **characterized in that** the first lateral flows (QL1ₚᵤᵣ-QL4ₚᵤᵣ) are directed in a direction forming an angle (θ) lying strictly between 0° and 90° relative to the vertical, notably less than or equal to 45°.

9. Method according to one of the preceding claims, **characterized in that** the first flow (QL1ₚᵤᵣ-QL4ₚᵤᵣ, QCₚᵤᵣ) is a purifying flow for the free surface of the material (15), comprising a gas, or a mixture of gases, that is inert with respect to the material to be treated.

10. Method according to one of the preceding claims, **characterized in that** the step (E2) of sweeping of the free surface of the material is implemented during an operation of crystallization of the material (5).

11. System comprising a device for treating a free surface of a material and a container (10) intended to contain the material to be treated, the device comprising a duct (200-201) for emission of at least one first gas flow (QL1ₚᵤᵣ-QL4ₚᵤᵣ and QCₚᵤᵣ) suitable for sweeping the free surface of the material then being evacuated by at least one evacuation zone (103a-103d), **characterized in that** the emission duct (200-201) comprises at least one lateral aperture (2000a-2000d) for emission of a second gas flow (Qaₚᵣₒ-Qdₚᵣₒ) suitable for forming a protective cover above the free surface of the material and spaced apart from said free surface, and for being evacuated by an upper part of the evacuation zone (103a-103d) of a container (10), a lower part of the evacuation zone (103a-103d) being used for the evacuation of the first flow (QL1ₚᵤᵣ-QL4ₚᵤᵣ and QCₚᵤᵣ), the container being provided with at least one evacuation apperture of the second flow through an upper part of said evacuation aperture and of the first flow through a remaining lower part of the evacuation aperture, said upper part of the evacuation aperture (103a-103d) occupying between 50% and 80% of the total height of the aperture (103a-103d), the duct (200-201) comprising two parts, upper (200) and lower (201), the section of the upper part being greater than that of the lower part, said lateral emission aperture (2000a-2000d) being formed in the upper part (200), the lower part (201) comprising an upper flange (2012) introduced into the upper part (200), said flange having at least one flow ramp (2014a-2014d) for a second flow (Qaₚᵣₒ-Qdₚᵣₒ) extending at least partially in line with the lateral emission aperture (2000a-2000d), said ramp being conformed to orient the second flow towards the upper part of the evacuation zone (103a-103d) .

12. System according to Claim 11, **characterized in that** the device comprises N lateral apertures (2000a-2000d) for emission of N respective second gas flows (Qaₚᵣₒ-Qdₚᵣₒ), N being greater than or equal to two, notably equal to four.

13. System according to Claim 11 or 12, **characterized in that** the flange (2012) forms a plurality of vertical slits (2015a-2015d), each slit comprising a bottom that is inclined relative to the vertical and forming a flow ramp for a first lateral flow (QL1ₚᵤᵣ-QL4ₚᵤᵣ), said ramp being suitable for orienting the first lateral flow towards a plurality of peripheral zones of the free surface of the material.

14. System according to one of Claims 11 to 13, **characterized in that** said lateral aperture (2000a-2000d) for emission of a second flow (QL1ₚᵤᵣ-QL4ₚᵤᵣ) is dimensioned so as to ensure a division of a feed gas flow into at least one second flow and at least one first flow according to predefined proportions.

15. System according to one of Claims 11 to 14, **characterized in that** said upper part of the evacuation aperture (103a-103d) occupies between 50% and 70% of said height.
